# EUROPEAN PATENT APPLICATION

(11) **EP 4 770 292 A1**
(43) Date of publication of application: **01.07.2026**
(21) Application number: 24855282.0
(22) Date of filing: 28.03.2024
(51) Int. Cl.: H05K 7/20, B60L 53/302

(54) **COOLING SYSTEM AND RELATED APPARATUS**

(30) Priority: 21.08.2023 CN 202322252699 U
(71) Applicant: Sungrow Power Supply Co., Ltd., Hefei, Anhui 230088 (CN)
(72) Inventor: WANG, Wei, Hefei, Anhui 230088 (CN); YU, Renbin, Hefei, Anhui 230088 (CN); ZHOU, Jie, Hefei, Anhui 230088 (CN); YANG, Ye, Hefei, Anhui 230088 (CN); ZHANG, Zhitong, Hefei, Anhui 230088 (CN); LIU, Long, Hefei, Anhui 230088 (CN)
(74) Representative: Zacco Norway AS
(86) International application number: PCT/CN2024/084323
(87) International publication number: WO 2025/039551

(57) **Abstract**

Disclosed in the present application are a cooling system and a related apparatus. The cooling system is used for a power conversion apparatus, the power conversion apparatus comprises a protective cavity and a device to be cooled in the protective cavity, and the cooling system comprises a cold plate, wherein the cold plate is attached to a cavity wall of the protective cavity; or the protective cavity is provided with an opening, and the cold plate is connected to the opening and is in direct or indirect contact with the device to be cooled. In the cooling system provided in the present application, the cold plate of the cooling system is attached to the cavity wall of the protective cavity, and heat dissipation of the device to be cooled in the protective cavity is realized by means of cooling the cavity wall; or the protective cavity is provided with the opening, and the cold plate is in direct or indirect contact with the device to be cooled by means of the opening, such that the device to be cooled is cooled by means of the cold plate. Compared with an air cooling method, a heat dissipation capability of the power conversion apparatus is improved by using an active heat dissipation method of cooling the device to be cooled by means of the cold plate in the present application.

## Description

The present application claims priority to the Chinese Patent Application No. 2023222526998, titled "COOLING SYSTEM AND RELATED APPARATUS", filed on August 21, 2023 with the China National Intellectual Property Administration, which is incorporated herein by reference in its entirety.

### FIELD

The present application relates to the technical field of electrical power equipment and, in particular, to a cooling system, a power conversion apparatus, a power conversion system and a multi-energy complementary energy station.

### BACKGROUND

In order to protect power electronic devices of a power conversion apparatus or other electrical products from damage caused by the external environment, a closed high-protective enclosure is typically formed to house and protect the power electronic devices from rain and dust. However, during operation, the power electronic devices generate a large amount of heat which is discharged into the closed enclosure. Since the heat within the closed enclosure can currently only be dissipated to the external environment through natural convection and thermal radiation from the shell, this passive heat dissipation is inefficient.

With the continuous increase in the power of power electronic products, there is a growing amount of heat accumulated within the closed enclosure, and the traditional passive heat dissipation is inadequate to meet the heat dissipation requirements of these products.

Thus, it is desired for those skilled in the art to improve the heat dissipation capacity of the power conversion apparatus.

### SUMMARY

In view of this, a first object of the present application is to provide a cooling system which can improve the heat dissipation capacity of a power conversion apparatus.

A second object of the present application is to provide a power conversion apparatus.

A third object of the present application is to provide a multi-energy complementary energy station.

In order to achieve the above first object, the following solutions are provided according to the present application.

There is provided a cooling system for a power conversion apparatus, which includes a protective enclosure and to-be-cooled devices located within the protective enclosure. The cooling system includes a cold plate.

The cold plate is attached to a wall of the protective enclosure, or the cold plate is connected to an opening formed in the protective enclosure and is in direct or indirect contact with the to-be-cooled devices.

In an embodiment, the cold plate is positioned outside the protective enclosure and is attached to an outer side of the wall of the protective enclosure.

Alternatively, the cold plate is positioned inside the protective enclosure and is attached to an inner side of the wall of the protective enclosure.

In another embodiment, the cold plate extends into the protective enclosure through the opening and is directly attached to the to-be-cooled device to achieve direct contact therebetween; or a heat dissipation member is arranged in the opening, and the to-be-cooled devices and the cold plate are respectively attached to both sides of the heat dissipation member to achieve indirect contact therebetween.

In another embodiment, there is at least one cold plate, which is at least attached to one wall of the protective enclosure.

In another embodiment, there is one cold plate, which is configured to be directly or indirectly attached to all of the to-be-cooled devices through the opening. Alternatively, the cold plate is configured to be attached to all of the to-be-cooled devices via the wall of the protective enclosure.

Alternatively, there are at least two cold plates. The cold plates are arranged in one-to-one correspondence with the to-be-cooled devices, and are directly or indirectly attached to the to-be-cooled devices through the opening, respectively; or, the cold plates are arranged in one-to-one correspondence with the to-be-cooled devices, and are attached to the to-be-cooled devices via the wall of the protective enclosure; or, a same cold plate is directly or indirectly attached to a same type of to-be-cooled devices through the opening, or a same cold plate is attached to a same type of to-be-cooled devices via the wall of the protective enclosure; or, a same cold plate is configured to be directly or indirectly attached to at least two different types of to-be-cooled devices through the opening, or a same cold plate is configured to be attached to at least two different types of to-be-cooled devices via the wall of the protective enclosure.

In another embodiment, there are two cold plates, which are arranged on two opposite walls of the protective enclosure, respectively. The to-be-cooled devices and the cold plates are attached to different walls of the protective enclosure.

In another embodiment, at least one rib structure is provided within the cold plate.

In another embodiment, the cooling system further includes a first fan.

The first fan is mounted within the protective enclosure and is configured to induce turbulence in the protective enclosure.

In another embodiment, the cooling system further includes a first heat exchanger.

The first heat exchanger is disposed within the protective enclosure. The to-be-cooled devices include a magnetic device and a power device. At least one of the magnetic devices is arranged around at least one side of the first heat exchanger, and at least one of the power devices is attached to the cold plate directly or indirectly via the wall of the protective enclosure.

In another embodiment, there are at least two first heat exchangers, and the magnetic devices are arranged in one-to-one correspondence with the first heat exchangers.

Alternatively, there are at least two first heat exchangers. At least one of the first heat exchangers is arranged in one-to-one correspondence with the magnetic device, and at least two other magnetic devices are arranged around one side of at least one other first heat exchangers.

In another embodiment, a first accommodating enclosure is provided within the protective enclosure to accommodate the first heat exchanger and the magnetic device arranged around the first heat exchanger.

In another embodiment, a cooling medium inlet of the first heat exchanger is in communication with a cooling medium outlet of the cold plate.

Or, the cooling medium inlet of the first heat exchanger is in communication with a cooling medium inlet of the cold plate, and a cooling medium outlet of the first heat exchanger is in communication with the cooling medium outlet of the cold plate.

Or, the cooling medium inlet of the cold plate is configured to input the cooling medium and is in communication with a first end of a first on-off valve. A second end of the first on-off valve is in communication with both the cooling medium inlet of the first heat exchanger and a first end of a second on-off valve. A second end of the second on-off valve is in communication with both the cooling medium outlet of the cold plate and a first end of the third on-off valve. A second end of the third on-off valve and the cooling medium outlet of the first heat exchanger are configured to output the cooling medium.

In another embodiment, the cooling system further includes a liquid cooling circulation system arranged outside the protective enclosure.

The liquid cooling circulation system includes a driving pump and a second heat exchanger. The driving pump is at least configured to supply a driving force required for circulation of the cooling medium in the cold plate, and the second heat exchanger is at least configured to cool the cooling medium output from the cold plate.

In another embodiment, the cooling system further includes a second accommodating enclosure.

The second accommodating enclosure is disposed outside the protective enclosure and is configured to at least accommodate the liquid cooling circulation system.

In another embodiment, the driving pump is integrated with the second heat exchanger.

Or, the second heat exchanger is a secondary heat exchanger with a compressor system.

In another embodiment, the second heat exchanger is arranged above the protective enclosure and is configured to cover at least a portion of a top end of the protective enclosure.

In another embodiment, the second heat exchanger is in the shape of a flat plate, an inclined plate, a V-shaped plate, a W-shaped plate or a wave.

In another embodiment, the liquid cooling circulation system further includes a water storage device.

The water storage device is configured to store the cooling medium.

In another embodiment, the water storage device is integrated with the driving pump.

Alternatively, the water storage device is integrated with both the driving pump and the second heat exchanger.

In another embodiment, the liquid cooling circulation system further includes a heating device.

The heating device is at least configured to heat the cooling medium input into the cold plate.

In another embodiment, the liquid cooling circulation system further includes a filter.

The filter is at least configured to filter the cooling medium input into the cold plate.

In another embodiment, the cooling system further includes a second fan disposed outside the protective enclosure.

The second fan is connected to the cold plate via an air duct and is configured to blow cold air into the cold plate.

The features in the various embodiments of the present application may be arbitrarily combined as required, and the embodiments obtained by combination are also within the scope of the present application and form a part of the embodiments of the present application.

The cooling system provided by the present application features a cold plate attached to the wall of the protective enclosure, dissipating heat from the to-be-cooled device in the protective enclosure by cooling the wall. Alternatively, the protective enclosure is formed with an opening, and the cold plate is in direct or indirect contact with the to-be-cooled device through the opening, so that the to-be-cooled device is cooled by the cold plate. Compared with the air cooling method, the active heat dissipation method according to the present application, in which the to-be cooled-device is cooled by the cold plate, enhances the heat dissipation capacity of the power conversion apparatus.

In order to achieve the above second object, the following solutions are provided according to the present application.

A power conversion apparatus includes a protective enclosure, to-be-cooled devices, and the cooling system as described in any of the above embodiments.

The to-be-cooled devices are disposed within the protective enclosure, and the to-be-cooled devices include a magnetic device and a power device.

The cold plate of the cooling system is at least configured to cool the power device.

Since the power conversion apparatus provided in the present application includes the cooling system described in any of the above embodiments, all the beneficial effects associated with the above cooling system are possessed by the power conversion apparatus disclosed in the present application.

In order to achieve the above third object, the following solutions are provided according to the present application.

A power conversion system includes multiple power conversion apparatuses as described in the above embodiments. The multiple power conversion apparatuses share a single liquid cooling circulation system.

Since the power conversion system provided in the present application includes the power conversion apparatus as described in any of the above embodiments, all the beneficial effects associated with the above power conversion apparatus are possessed by the power conversion system disclosed in the present application.

In order to achieve the above third object, the following solutions are provided according to the present application.

A multi-energy complementary energy station includes the cooling system as described in any of the above embodiments, or the power conversion apparatus as described in any of the above embodiments, or the power conversion system as described in any of the above embodiments.

Since the multi-energy complementary energy station provided in the present application includes the cooling system as described in any of the above embodiments, the power conversion apparatus as described in the above-mentioned embodiments, or the power conversion system as described in the above-mentioned embodiments, all the beneficial effects associated with the above cooling system, the power conversion apparatus or the power conversion system are possessed by the multi-energy complementary energy station disclosed in the present application.

### BRIEF DESCRIPTION OF THE DRAWINGS

In order to more clearly illustrate the technical solutions in the embodiments of the present application or in the conventional technology, the accompanying drawings required for describing the embodiments or the conventional technology will be briefly introduced below. Obviously, the accompanying drawings described below merely show some embodiments of the present application. For those ordinary skilled in the art, other drawings can be obtained based on these accompanying drawings without any creative efforts.
FIG. 1 is a schematic view showing a heat dissipation arrangement of a cooling system for a power conversion apparatus according to a first embodiment of the present application;
FIG. 2 is a schematic view showing a heat dissipation arrangement of a cooling system for a power conversion apparatus according to a second embodiment of the present application;
FIG. 3 is a schematic view showing a heat dissipation arrangement of a cooling system for a power conversion apparatus according to a third embodiment of the present application;
FIG. 4 is a schematic view showing a heat dissipation arrangement of a cooling system for a power conversion apparatus according to a fourth embodiment of the present application;
FIG. 5 is a schematic view showing a heat dissipation arrangement of a cooling system for a power conversion apparatus according to a fifth embodiment of the present application;
FIG. 6 is a schematic view showing a heat dissipation arrangement of a cooling system for a power conversion apparatus according to a sixth embodiment of the present application;
FIG. 7 is a schematic structural view showing series-parallel connection between a first heat exchanger and a cold plate in the cooling system according to the sixth embodiment of the present application;
FIG. 8 is a schematic view showing a heat dissipation arrangement of a cooling system for a power conversion apparatus according to a seventh embodiment of the present application;
FIG. 9 is a schematic view showing a heat dissipation arrangement of a cooling system for a power conversion apparatus according to an eighth embodiment of the present application;
FIG. 10 is a schematic view showing a heat dissipation arrangement of a cooling system for a power conversion apparatus according to a ninth embodiment of the present application;
FIG. 11 is a schematic view showing a heat dissipation arrangement of a cooling system for a power conversion apparatus according to a tenth embodiment of the present application;
FIG. 12 is a schematic view showing a heat dissipation arrangement of a cooling system for a power conversion apparatus according to an eleventh embodiment of the present application;
FIG. 13 is a schematic view showing a heat dissipation arrangement of a cooling system for a power conversion apparatus according to a twelfth embodiment of the present application;
FIG. 14 is a schematic view showing a heat dissipation arrangement of a cooling system for a power conversion apparatus according to a thirteenth embodiment of the present application;
FIG. 15 is a schematic view showing a heat dissipation arrangement of a cooling system for a power conversion apparatus according to a fourteenth embodiment of the present application;
FIG. 16 is a schematic perspective view showing a heat dissipation arrangement of a cooling system for a power conversion apparatus according to the fifteenth embodiment of the present application;
FIG. 17 is another schematic perspective view showing the heat dissipation arrangement of the cooling system for the power conversion apparatus according to the fifteenth embodiment of the present application;
FIG. 18 is a schematic structural right view showing the heat dissipation arrangement of the cooling system for the power conversion apparatus according to a fifteenth embodiment of the present application;
FIG. 19 is a schematic sectional view of FIG. 18 taken along line A-A;
FIG. 20 is a schematic sectional view of FIG. 19 taken along line B-B;
FIG. 21 is a schematic perspective view showing a heat dissipation arrangement of a cooling system for a power conversion apparatus according to a sixteenth embodiment of the present application;
FIG. 22 is another schematic perspective view showing the heat dissipation arrangement of the cooling system for the power conversion apparatus according to the sixteenth embodiment of the present application;
FIG. 23 is a schematic perspective view showing a heat dissipation arrangement of a cooling system for a power conversion apparatus according to a seventeenth embodiment of the present application;
FIG. 24 is another schematic perspective view showing the heat dissipation arrangement of the cooling system for the power conversion apparatus according to the seventeenth embodiment of the present application; and
FIG. 25 is a schematic sectional view of a power conversion system provided in the present application.

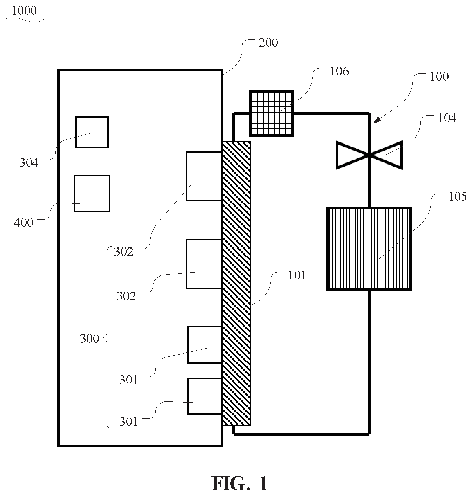

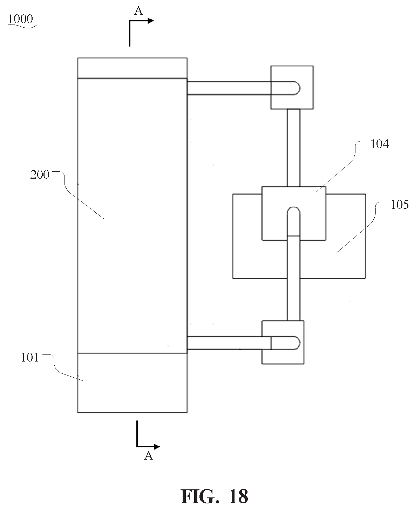

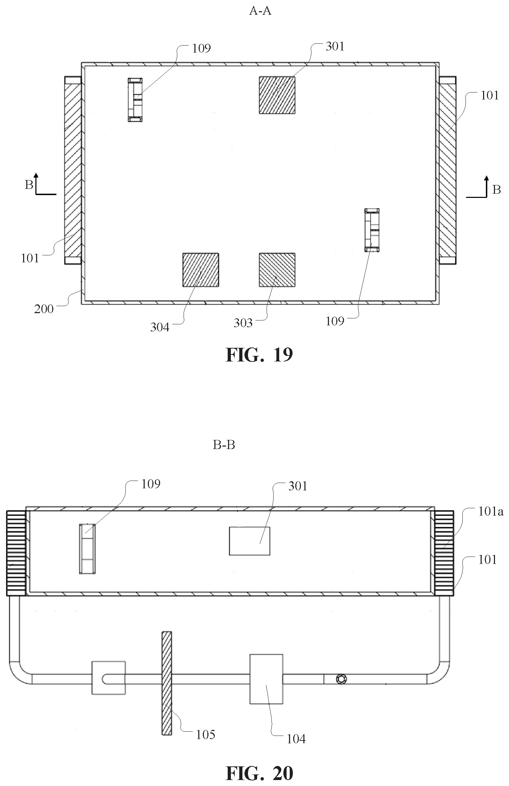

List of numeral references in FIGS. 1 to 25:
100. cooling system; 101. cold plate; 101a. rib structure; 102. first heat exchanger; 103. first accommodating enclosure; 104. driving pump; 105. second heat exchanger; 106. water storage device; 107. heating device; 108. filter; 109. first fan; 110. first on-off valve; 111. second on-off valve; 112. third on-off valve; 113. second fan; 114. second accommodating enclosure; 200. protective enclosure; 300. to-be-cooled device; 301. magnetic device; 302. power device; 303. switching device; 304. electronic device; 400. capacitor device; 1000. power conversion apparatus; 10000. power conversion system.

### DETAILED DESCRIPTION OF THE EMBODIMENTS

The technical solutions in the embodiments of the present application will be described clearly and comprehensively below with reference to FIGS. 1 to 25. Apparently, the described embodiments are only some rather than all of the embodiments of the present application. All other embodiments obtained by those skilled in the art based on the embodiments of the present application without any creative effort fall within the protection scope of the present application.

In the description of the present application, it should be noted that the orientation or positional relationships indicated by terms such as "upper", "lower", "top", "bottom" and the like are defined based on the orientation or positional relationships shown in the accompanying drawings. They are used merely for the convenience of describing the present application and simplifying the description, rather than indicating or implying that a device or element referred to must have a particular orientation, or be configured and operated in a particular orientation. Therefore these terms should not be construed as limitations to the present application. In addition, the terms such as "first", "second" and the like are merely for descriptive purposes, and should not be construed as indicating or implying the relative importance.

With reference to FIGS. 1 to 24, a cooling system 100 is provided according to a first aspect of the present application, which is used for a power conversion apparatus 1000. The power conversion apparatus 1000 includes a protective enclosure 200 and a to-be-cooled device 300 located within the protective enclosure 200. The to-be-cooled device 300 is attached to an inner wall of the protective enclosure 200. The cooling system 100 is configured to cool the to-be-cooled device 300 and improve the heat dissipation efficiency of the power conversion apparatus 1000.

The cooling system 100 includes a cold plate 101. The cold plate 101 is attached to a wall of the protective enclosure 200, thereby dissipating heat from and cooling the to-be-cooled device 300 by cooling the wall of the protective enclosure 200. In this regard, the cold plate 101 may be positioned outside the protective enclosure 200 and attached to an outer side of the wall of the protective enclosure 200, or the cold plate 101 may be positioned inside the protective enclosure 200 and attached to an inner side of the wall of the protective enclosure 200. It can be understood that the outer side of the wall of the protective enclosure 200 refers to the side of the wall of the protective enclosure 200 that is facing away from an internal cavity of the protective enclosure 200, and that the inner side of the wall of the protective enclosure 200 refers to the side of the wall of the protective enclosure 200 that faces towards the internal cavity of the protective enclosure 200. There is at least one cold plate 101, which is at least attached to one wall of the protective enclosure 200. Taking a rectangular protective enclosure 200 as an example, the cold plate(s) 101 may be attached to only one wall of the protective enclosure 200, or may be attached to two or three walls of the protective enclosure 200, or may cover all walls of the protective enclosure 200, improving the cooling efficiency.

Alternatively, the protective enclosure 200 may be provided with an opening. The cold plate 101 is connected to the opening and is in direct or indirect contact with the to-be-cooled device 300, thereby enabling the cold plate 101 to cool the to-be-cooled device 300. In an embodiment of the direct contact between the to-be-cooled device 300 and the cold plate 101 the opening extends through the wall of the protective enclosure 200, and the cold plate 101 extends into the protective enclosure 200 through the opening and directly abuts against the to-be-cooled device 300, thereby achieving the direct contact therebetween. In an embodiment of the indirect contact between the to-be-cooled device 300 and the cold plate 101, the opening extends through the wall of the protective enclosure 200, and a heat dissipation member is arranged in the opening, with the to-be-cooled device 300 and the cold plate 101 being attached to opposite sides of the heat dissipation member respectively, thereby achieving the indirect contact therebetween. The heat dissipation member may be configured as a heat sink, heat dissipation fins, a heat dissipation plate with multiple through-holes, or the like, which is disposed in the opening. Alternatively, the heat dissipation member may be configured as thermal grease, a thermally conductive pad, a welding layer, or the like.

Compared with the air cooling method, the active heat dissipation method according to the present application, in which the to-be-cooled device 300 is cooled by the cold plate 101, enhances the heat dissipation capacity of the power conversion apparatus 1000.

Furthermore, the cold plate 101 may be directly tightly fitted to, welded to, or coated with an interface material before being connected to the protective enclosure 200.

### First Embodiment

As shown in FIG. 1, in this embodiment, the cold plate 101 is positioned outside of the protective enclosure 200. The cooling system 100 further includes a liquid cooling circulation system, which is arranged outside the protective enclosure 200. The liquid cooling circulation system is configured to supply a cooling medium such as coolant liquid, which is circulated for cooling, to the cold plate 101101.

The liquid cooling circulation system includes a driving pump 104 and a second heat exchanger 105. The driving pump is at least configured to supply a driving force required for the circulation of the coolant liquid within the cold plate 101, enabling the coolant liquid to circulate through the cold plate 101 to cool the cold plate 101. For instance, the driving pump 104 is configured as a water pump or the like. The second heat exchanger is at least configured to cool the coolant liquid output from the cold plate 101, thereby enabling the cold plate 101 to continuously cool the to-be-cooled device 300.

It should be noted that the relative positions of the second heat exchanger 105 and the driving pump 104 are not limited. For example, an inlet of the second heat exchanger 105 is in communication with a cooling medium outlet of the cold plate 101, and an outlet of the second heat exchanger 105 is in communication with an inlet of the driving pump 104, and an outlet of the driving pump 104 is in communication with a cooling medium inlet of the cold plate 101. In other words, the driving pump 104 is configured to transport the coolant liquid cooled in the second heat exchanger 105 to the cold plate 101, and then pump the coolant liquid flowing through the cold plate 101 and heated by the to-be-cooled device 300 to the second heat exchanger 105 for cooling, thereby forming a cooling circulation loop.

Alternatively, the inlet of the driving pump 104 is in communication with the cooling medium outlet of the cold plate 101, and the outlet of the driving pump 104 is in communication with the inlet of the second heat exchanger 105, and the outlet of the second heat exchanger 105 is in communication with the cooling medium inlet of the cold plate 101. In other words, the driving pump 104 is configured to pump the coolant liquid from the cold plate 101 to the second heat exchanger 105 for heat exchange and cooling, and then delivery the coolant liquid to the cold plate 101 for heat exchange with the to-be-cooled device 300, thereby forming a cooling circulation loop.

Moreover, the liquid cooling circulation system may further include a water storage device 106, which is configured to store the coolant liquid so as to achieve buffering of the coolant liquid.

It should be noted that the position of the water storage device 106 is not limited. For example, an inlet of the water storage device 106 is in communication with the outlet of the driving pump 104, and an outlet of the water storage device 106 is in communication with the cooling medium inlet of the cold plate 101. In other words, the water storage device 106 essentially serves as a buffer for the coolant liquid output from the driving pump 104.

Alternatively, the inlet of the water storage device 106 may be in communication with the outlet of the second heat exchanger 105.

It should also be noted that the "communication" described herein may be achieved either through pipelines, or by directly connecting ports of components.

There may be a single cold plate 101, which is attached to all the to-be-cooled devices 300 directly or indirectly via the wall of the protective enclosure 200.

The same cold plate 101 is used to dissipate heat from all of the to-be-cooled devices 300 spaced apart from each other, so that the cooling system 100 has a minimal number of components and a simple structure.

### Second Embodiment

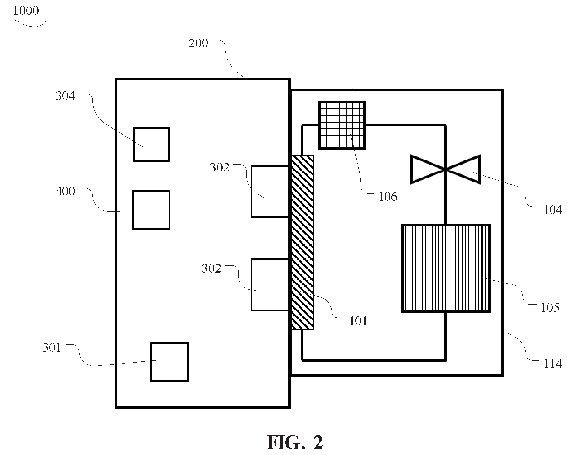

The structure of the cooling system 100 in the embodiment as shown in FIG. 2 is similar to that in the first embodiment, except that the cold plate 101 is directly or indirectly attached to a power device 302 of the to-be-cooled devices 300 and the cooling system 100 further includes a second accommodating enclosure 114. The second accommodating enclosure 114 is positioned outside the protective enclosure 200 and is configured to accommodate at least the liquid cooling circulation system. The provision of the second accommodating enclosure 114 at least provides protection to the liquid cooling circulation system from damage caused by exposure to wind, rain or the like.

The second accommodating enclosure 114 may be mounted on an outer wall of the protective enclosure 200, so that the second accommodating enclosure 114 and the protective enclosure 200 are connected to form a single unit, facilitating the transportation of the power conversion apparatus 1000. Alternatively, the second accommodating enclosure 114 and the protective enclosure may be separately arranged, that is, there is no connection between them. In this case, the second accommodating enclosure 114 and the protective enclosure may be transported separately.

The cold plate 101 may be also positioned within the second accommodating enclosure 114. In this case, the second accommodating enclosure 114 is mounted on the outer wall of the protective enclosure 200, as shown in FIG. 2, thereby preventing the cold plate 101 from damage caused by exposure to wind, rain or the like.

### Third Embodiment

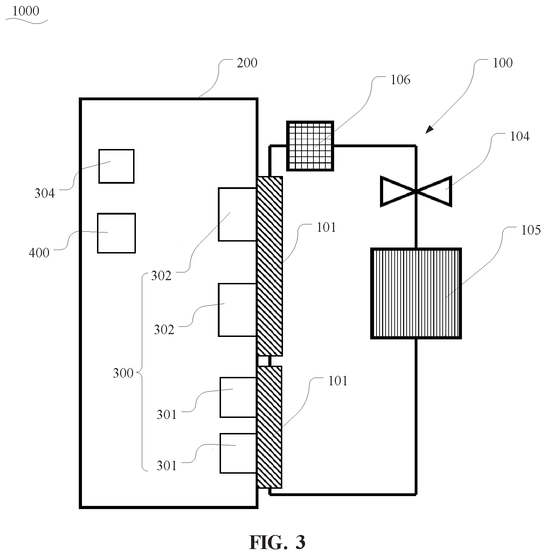

The structure of the cooling system 100 in the embodiment as shown in FIG. 3 is similar to that in the first embodiment, except that there are at least two cold plates 101. The cold plates 101 may be sequentially connected in series or in parallel with each other. Alternatively, if there are three or more cold plates 101, at least two of the cold plates 101 may be connected in series, and then connected in parallel with the other cold plate(s) 101; or at least two of the cold plates 101 may be connected in parallel, and then connected in series with the other cold plate(s) 101.

It should be noted that such an expression as "series connection" herein refers to that an inlet of a component is connected to an outlet of an adjacent component; and such an expression as "parallel connection" herein refers to that an inlet of a component is connected to an inlet of an adjacent component, and an outlet of the component is connected to an outlet of the adjacent component.

A same cold plate 101 may be attached to the same type of the to-be-cooled devices 300 directly or indirectly via the wall of the protective enclosure 200, which facilitates mounting different types of to-be-cooled devices 300.

As an example, the to-be-cooled devices 300 include two types, namely, power devices 302 and magnetic devices 301. There are provided two cold plates 101, one of which is configured to cool the power devices 302, and the other of which is configured to cool the magnetic devices 301.

The cold plates 101 may be attached to the to-be-cooled devices 300 in one-to-one correspondence directly or indirectly via the wall of the protective enclosure 200.

### Fourth Embodiment

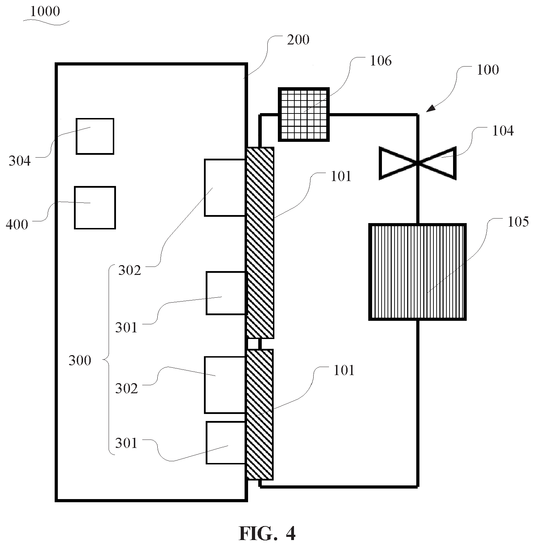

The structure of the cooling system 100 in the embodiment as shown in FIG. 4 is similar to that in the third embodiment, except that a same cold plate 101 is configured to be attached to at least two different types of to-be-cooled devices 300 directly or indirectly via the wall of the protective enclosure 200, facilitating uniform heat dissipation of the to-be-cooled devices 300.

As an example, the to-be-cooled devices 300 include two types, namely, power devices 302 and magnetic devices 301. There are provided two cold plates 101, each of which is configured to cool both the power device(s) 302 and the magnetic device(s) 301.

### Fifth Embodiment

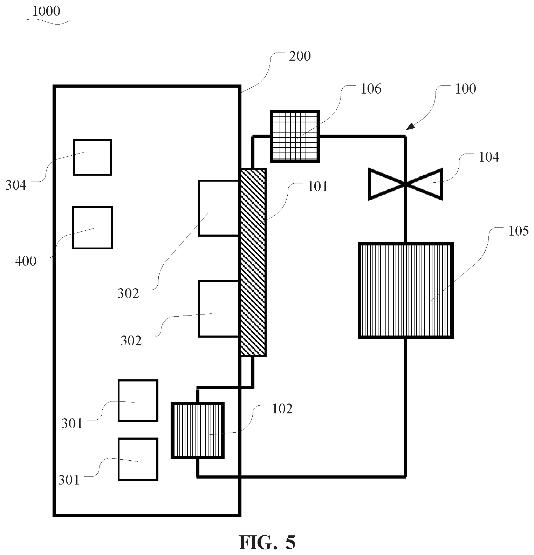

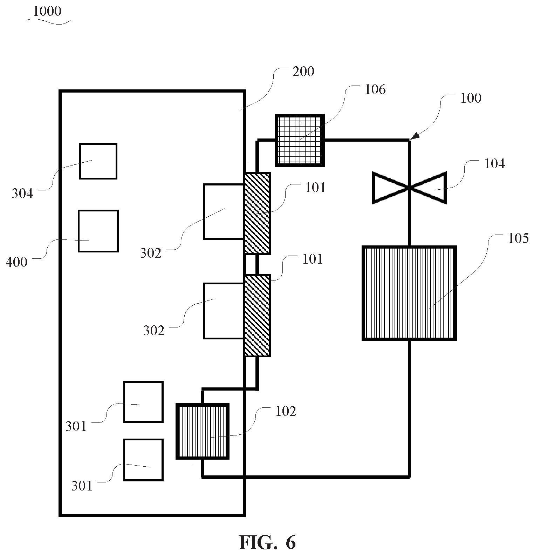

The structure of the cooling systems 100 in the embodiments as shown in FIGS. 5 and 6 is similar to that in the first embodiment, except that the cooling system 100 further includes a first heat exchanger 102, which is disposed within the protective enclosure 200. A cooling medium inlet of the first heat exchanger 102 is in communication with the cooling medium outlet of the cold plate 101. That is to say, the first heat exchanger 102 and the cold plate 101 are connected in series.

Alternatively, the cooling medium inlet of the first heat exchanger 102 may be in communication with the cooling medium inlet of the cold plate 101, and the cooling medium outlet of the first heat exchanger 102 may be in communication with the cooling medium outlet of the cold plate 101. That is to say, the first heat exchanger 102 and the cold plate 101 are connected in parallel.

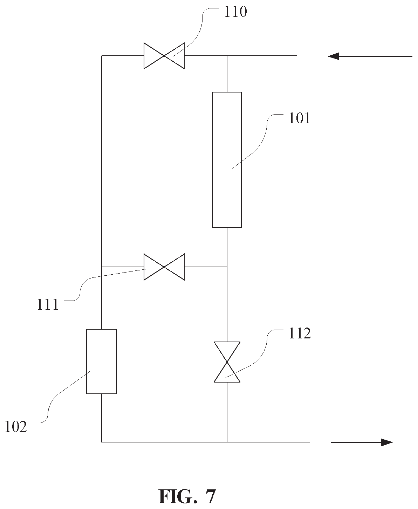

In an alternative embodiment, as shown in FIG. 7, the cooling medium inlet of the cold plate 101 is configured to input the cooling medium and is in communication with a first end of a first on-off valve 110; a second end of the first on-off valve 110 is in communication with both the cooling medium inlet of the first heat exchanger 102 and a first end of a second on-off valve 111; a second end of the second on-off valve 111 is in communication with both the cooling medium outlet of the cold plate and a first end of the third on-off valve 112; and a second end of the third on-off valve 112 and the cooling medium outlet of the first heat exchanger 102 are each configured to output the cooling medium.

That is to say, the first heat exchanger 102 and the cold plate 101 are in a series-parallel connection. When both the first on-off valve 110 and the third on-off valve 112 are closed and the second on-off valve 111 is opened, the first heat exchanger 102 and the cold plate 101 are connected in series. When both the first on-off valve 110 and the third on-off valve 112 are opened and the second on-off valve 111 is closed, the first heat exchanger 102 and the cold plate 101 are connected in parallel

The first heat exchanger 102 and the cold plate 101 are switched between the series connection mode and the parallel connection mode by controlling the on-off state of the first on-off valve 110, the second on-off valve 111 and the third on-off valve 112, which is convenient and quick and adapted to the heat dissipation requirements under different operating conditions.

The to-be-cooled device 300 includes a magnetic device 301 and a power device 302. At least one magnetic device 301 is arranged around at least one side of the first heat exchanger 102, and at least one power device 302 is attached to the cold plate 101 directly or indirectly via the wall of the protective enclosure 200. That is to say, the cold plate 101 is configured to cool the power device 302, and first heat exchanger 102 is configured to cool the magnetic device 301.

As shown in FIG. 5, there is provided a single first heat exchanger 102, with all of the magnetic devices 301 of the to-be-cooled devices 300 being arranged around one side of the first heat exchanger 102, and there is provided a single cold plate 101, with all of the power devices 302 being attached to the cold plate 101 directly or indirectly via the wall of the protective enclosure 200, achieving rapid cooling of all the to-be-cooled devices 300.

As shown in FIG. 6, there is provided a single first heat exchanger 102, with all of the magnetic devices 301 of the to-be-cooled devices 300 being arranged around one side of the first heat exchanger 102, and there are provided two cold plates 101, with the power devices 302 being arranged in one-to-one correspondence with the cold plates 101 and each being attached to the respective cold plates 101 directly or indirectly via the wall of the protective enclosure 200, achieving rapid cooling of all the to-be-cooled devices 300.

### Sixth Embodiment

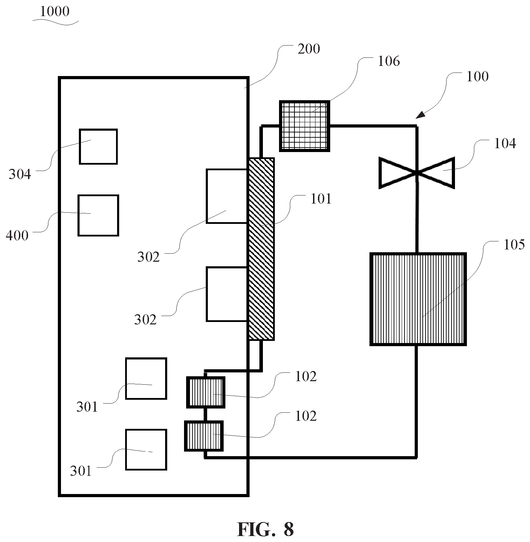

The structure of the cooling system 100 in the embodiment as shown in FIG. 8 is similar to that in the fifth embodiment, except that there are at least two first heat exchangers 102 and the magnetic devices 301 are arranged in one-to-one correspondence with the first heat exchangers 102.

Taking two magnetic devices 301 as an example, there are provided two first heat exchangers 102. Each first heat exchanger 102 is configured to cool one magnetic device 301, thereby enhancing the heat dissipation efficiency.

The first heat exchangers 102 may be connected in series or in parallel. If there are three or more first heat exchangers 102, two of the first heat exchangers 102 may be connected in parallel, and then connected in series with the other cold plate(s).

It should also be noted that the arrangement of the first heat exchanger(s) 102 and the magnetic device(s) 301 may be designed as actually required. For example, at least one of the first heat exchangers 102 may be arranged in one-to-one correspondence with at least one magnetic device 301, and at least two other magnetic devices 301 may be arranged around one side of at least one other first heat exchanger 102.

### Seventh Embodiment

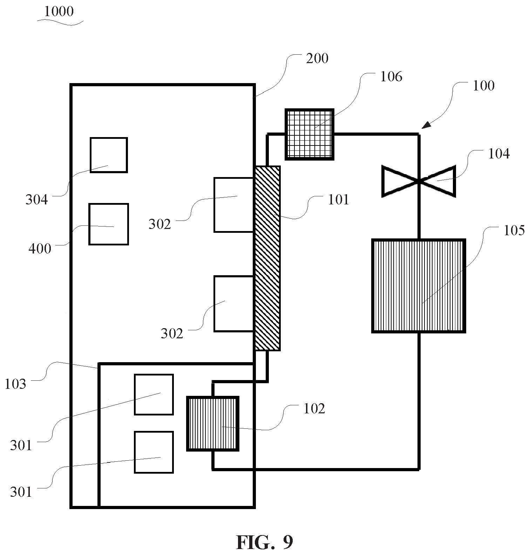

The structure of the cooling system 100 in the embodiment as shown in FIG. 9 is similar to that in the fifth embodiment, except that a first accommodating enclosure 103 is provided within the protective enclosure 200 to accommodate the first heat exchanger 102 and the magnetic devices 301 arranged around the first heat exchanger 102.

In this embodiment, by providing the first accommodating enclosure 103 within the protective enclosure 200, the magnetic devices 301 and the first heat exchanger 102 are isolated from the power devices 302. Since the magnetic devices 301 operate at a high temperature, placing them within an independent enclosure may reduce the impact on the ambient temperature inside the protective enclosure 200 and on other devices.

### Eighth Embodiment

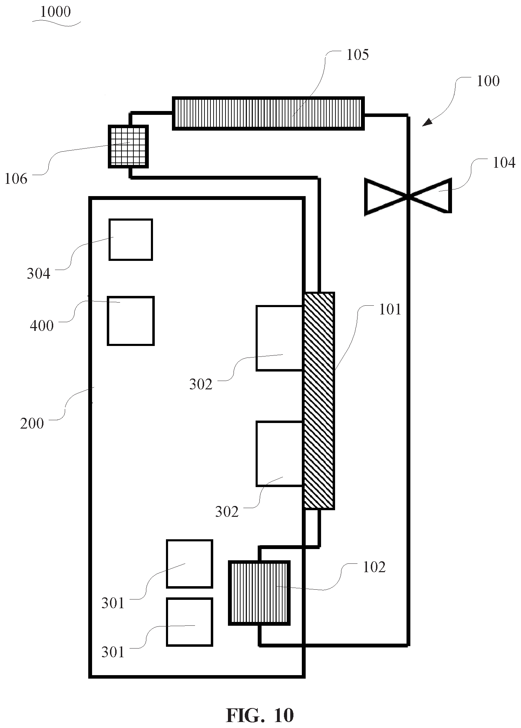

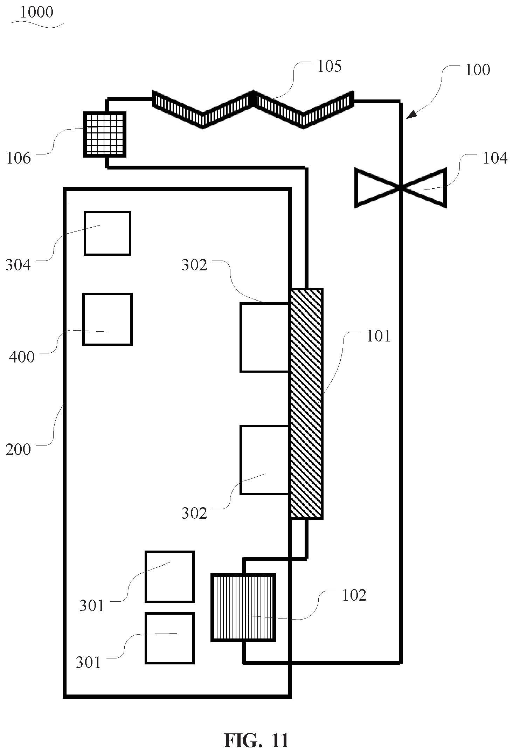

The structure of the cooling system 100 in the embodiments as shown in FIGS. 10 and 11 is similar to that in the fourth embodiment, except that the second heat exchanger 105 is arranged above the protective enclosure 200 and is configured to cover at least a portion of a top end of the protective enclosure 200. This arrangement of the second heat exchanger 105, on one hand, may effectively utilize the space, allowing for a larger heat exchange area of the second heat exchanger 105 and thereby enhancing the heat dissipation effect; and, on the other hand, may provide covering function, reducing the heating effect of direct sunlight on the protective enclosure 200 when the power conversion apparatus 1000 operates in an outdoor environment. It should be noted that the first heat exchanger 102 may be arranged at a back side, a side surface or a bottom of the protective enclosure 200.

As shown in FIG. 10, the second heat exchanger 105 is in form of a flat plate. Alternatively, the second heat exchanger 105 may be configured in form of a W-shaped plate, as shown in FIG. 11. Furthermore, the second heat exchanger 105 may be configured in form of an inclined plate, a V-shaped plate, a corrugated plate, etc.

### Ninth Embodiment

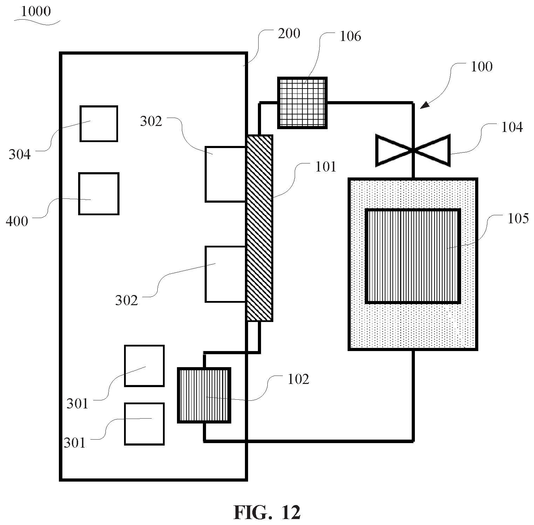

The structure of the cooling system 100 in the embodiment as shown in FIG. 12 is similar to that in the fifth embodiment, except that the second heat exchanger 105 is a secondary heat exchanger including a compressor system. When the power conversion apparatus 1000 operates at a relatively high ambient temperature, the compressor system may be configured to lower the temperature of the coolant liquid below the ambient temperature, thereby achieving a better heat dissipation effect.

### Tenth Embodiment

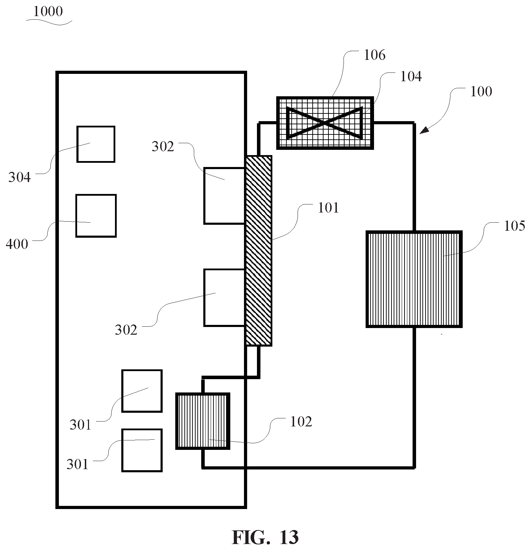

The structure of the cooling system 100 in the embodiment as shown in FIG. 13 is similar to that in the fifth embodiment, except that the water storage device 106 is integrated with the driving pump 104. In an alternative embodiment, the water storage device 106 may be integrated with the second heat exchanger 105. If the second heat exchanger 105 is configured to be of a water-to-air type that utilizes a fan, the fan may be integrated with a rotating component such as a main shaft of the driving pump 104, achieving integration of the driving pump 104 and the second heat exchanger 105. In another alternative embodiment, the water storage device 106, the water pump and the first heat exchanger 102 may be integrated into a single unit, thereby simplifying the complexity of the cooling system 100 and reducing the length of pipelines required to connect adjacent components.

### Eleventh Embodiment

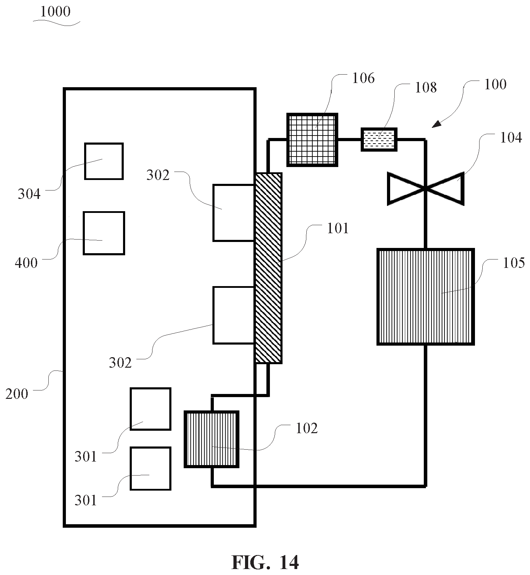

The structure of the cooling system 100 in the embodiment as shown in FIG. 14 is similar to that in the fifth embodiment, except that the cooling system 100 further includes a filter 108. The filter 108 is arranged at the inlet of the cold plate 101 and is configured to filter the coolant liquid delivered into the cold plate 101. The filter 108 may filter impurities in the liquid cooling circuit, enhancing the operational stability and lifespan of the cooling system 100.

An inlet of the filter 108 is in communication with the outlet of the driving pump 104, and an outlet of the filter 108 is in communication with the inlet of the water storage device 106. That is to say, the filter 108 is in communication with the cold plate 101 via the water storage device 106.

### Twelfth Embodiment

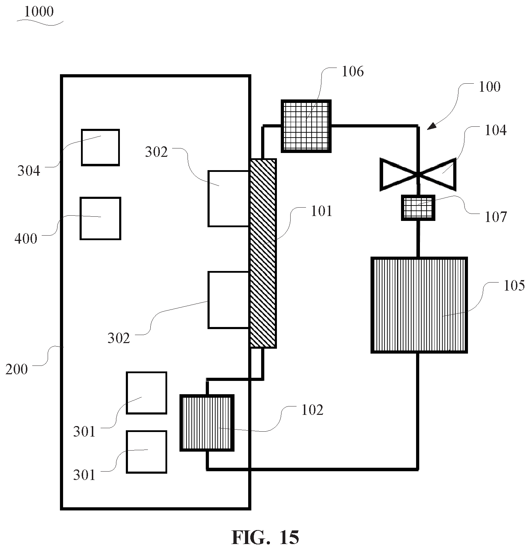

The structure of the cooling system 100 in the embodiment as shown in FIG. 15 is similar to that in the fifth embodiment, except that the cooling system 100 further includes a heating device 107. An inlet of the heating device 107 is in communication with the outlet of the second heat exchanger 105, and an outlet of the heating device 107 is in communication with the inlet of the driving pump 104. That is to say, the heating device 107 is arranged between the second heat exchanger 105 and the driving pump 104.

Alternatively, the heating device 107 may be arranged between the driving pump 104 and the cold plate 101. That is to say, the inlet of the heating device 107 is in communication with the outlet of the driving pump 104, and the outlet of the heating device 107 is in communication with the cooling medium inlet of the cold plate 101.

Alternatively, the heating device 107 may be arranged between the driving pump 104 and the water storage device 106. That is to say, the inlet of the heating device 107 is in communication with the outlet of the driving pump 104, and the outlet of the heating device 107 is in communication with the inlet of the water storage device 106.

### Thirteenth Embodiment

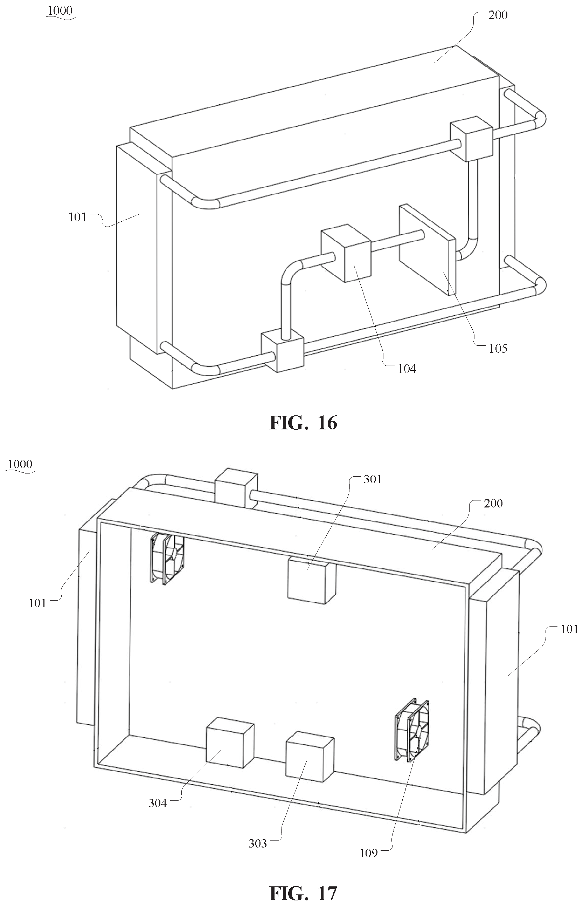

The structure of the cooling system 100 in the embodiment as shown in FIGS. 16 to 20 is similar to that in the first embodiment, except that the liquid cooling circulation system includes a driving pump 104 and a second heat exchanger 105, and that there are provided two cold plates 101 arranged on two opposite walls of the protective enclosure 200 respectively, and that the to-be-cooled devices 300 and the cold plates 101 are attached to different walls of the protective enclosure 200 respectively. In other words, the heat dissipation of the to-be-cooled device 300 is achieved by using the cold plates 101 to cool the walls of the protective enclosure 200. The to-be-cooled device 300 may include a magnetic device 301, a power device 302 and a switching device 303.

In this embodiment, since the cold plates 101 are arranged on two opposite walls of the protective enclosure 200, the driving pump 104 and the second heat exchanger 105 may be arranged on a wall adjacent to the two walls, resulting in a more compact structure of the cooling system 100 and the protective enclosure 200. In addition, the provision of the two cold plates 101 enhances the efficiency of dissipating heat from the to-be-cooled device 300.

Moreover, the cooling system further includes a first fan 109, which is mounted inside the protective enclosure 200 and configured to induce turbulence within the protective enclosure 200, thereby further enhancing the heat dissipation efficiency of the to-be-cooled device 300. It can be understood that the number of the first fan 109 is not limited. In this embodiment, two first fans 109 are taken as an example.

In order to further improve the heat dissipation efficiency of the to-be-cooled device 300, at least one rib structure 101a is arranged within the cold plate 101. The rib structure 101a may be in the form of a partition rib or the like. The partition rib may be configured to divide the internal cavity of the cold plate 101 into multiple independent units. Alternatively, partition ribs may be arranged only at top and bottom ends of the cold plate 101. Alternatively, curved partition ribs may be arranged within the internal cavity of the cold plate 101 to form, for example, a serpentine flow channel.

### Fourteenth Embodiment

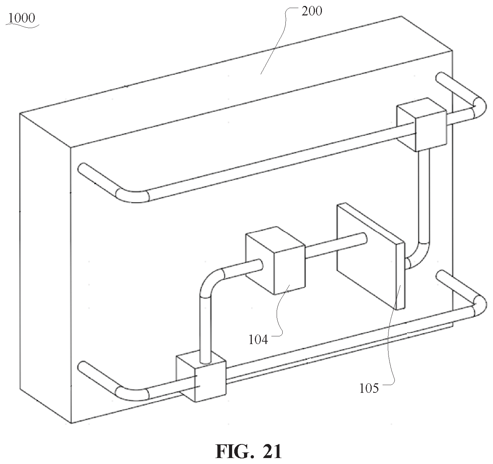

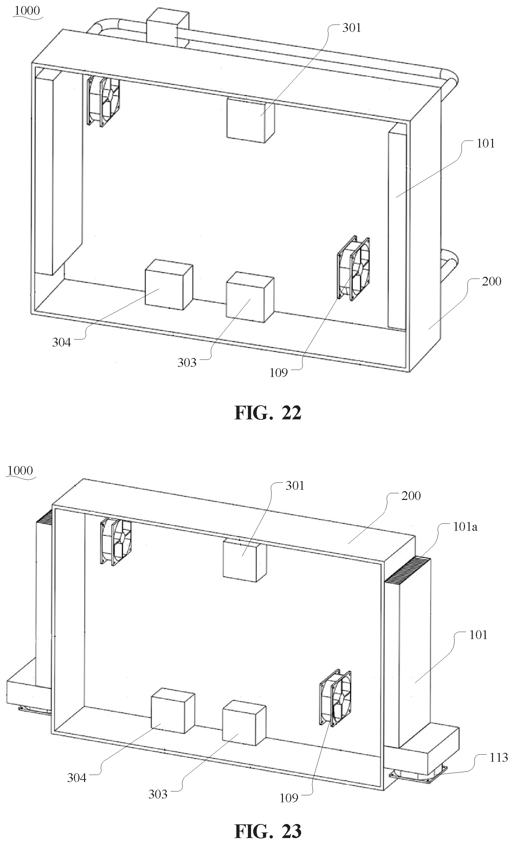

The structure of the cooling system 100 in the embodiment as shown in FIGS. 21 and 22 is similar to that in the thirteenth embodiment, except that the cold plates 101 are arranged inside the protective enclosure 200 and are attached to the inner side of the wall of the protective enclosure 200.

The protective enclosure 200 is formed with a hole, and the cold plate 101 is in communication with the liquid cooling circulation system through a pipe. While ensuring high-level protection of the protective enclosure 200, the driving pump 104 is configured to deliver the coolant liquid into the cold plate 101 via the pipe. As the coolant liquid passes through the cold plate 101, it exchanges heat with the air inside the protective enclosure 200, carrying away the heat from the protective enclosure 200. Subsequently, the hot coolant liquid flows into the second heat exchanger 105 to be cooled, and the cooled coolant liquid flows into the cold plate 101 again for heat dissipation.

In this embodiment, the cold plate 101 is arranged within the protective enclosure 200, which shortens the heat conduction path, further enhancing the heat dissipation capacity.

### Fifteenth Embodiment

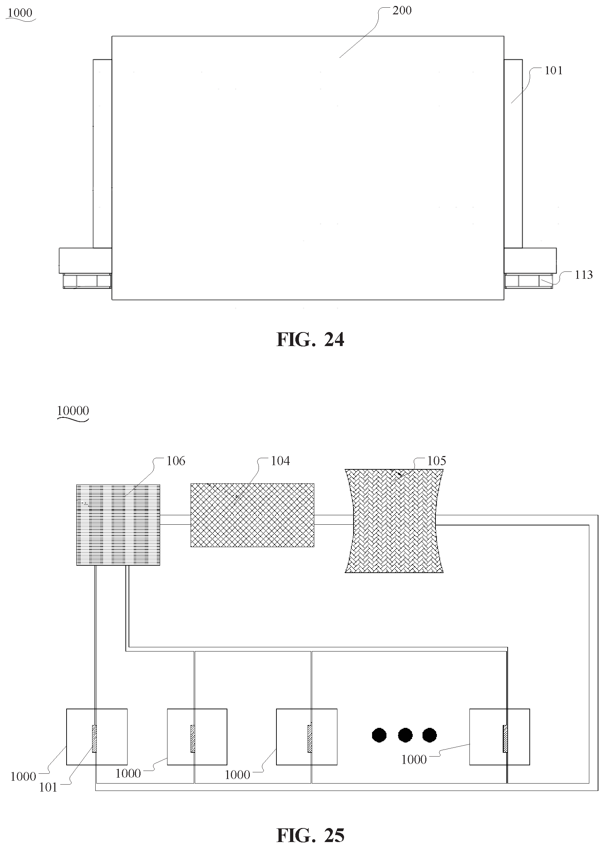

The structure of the cooling system 100 in the embodiment as shown in FIGS. 23 and 24 is similar to that in the thirteenth embodiment, except that the cold plate 101 is cooled by air. The cooling system further includes a second fan 113 arranged outside the protective enclosure 200. Moreover, the second fan 113 is connected to the cold plate 101 via an air duct, and is configured to blow cold air into the cold plate 101.

The cold air is delivered to the cold plate 101 by the second fan 113 to carry away the heat from the protective enclosure 200. Subsequently, hot air is directly discharged into the external atmospheric environment. By utilizing cold air as the cooling medium, the heat dissipation cost is reduced.

Referring to FIGS. 1 to 24, a power conversion apparatus 1000 is provided according to a second aspect of the present application, which includes a protective enclosure 200, a to-be-cooled device 300, and the cooling system 100 as described in any of the above embodiments.

The to-be-cooled device 300 is disposed within the protective enclosure 200, and the to-be-cooled device 300 includes a magnetic device 301 and a power device 302. The cold plate 101 of the cooling system 100 is configured to cool at least the power device 302.

Furthermore, the power conversion apparatus 1000 further includes an electronic device 304 and a capacitor device 400 that are located within the protective enclosure 200.

Since the power conversion apparatus 1000 provided in the present application includes the cooling system 100 described in any of the above embodiments, all the beneficial effects associated with the above cooling system 100 are possessed by the power conversion apparatus 1000 disclosed in the present application.

As shown in FIG. 25, a power conversion system 10000 is provided according to a third aspect of the present application. The power conversion system 10000 includes multiple power conversion apparatuses 1000 as described in the above embodiments. The multiple power conversion apparatuses 1000 share a single liquid cooling circulation system.

The liquid cooling circulation system includes a driving pump 104, a second heat exchanger 105 and a water storage device 106. The water storage device 106 may be a water tank or the like.

The cold plates 101 are arranged in parallel on the multiple power conversion apparatuses 1000. As a result, under the action of the driving pump 104, the coolant liquid in the water storage device 106 can enter the cold plate(s) 101 of each of the power conversion apparatuses 1000 to cool the to-be-cooled devices 300. This avoids the issues of a large number of components and high cost caused by providing one liquid cooling circulation system for each power conversion apparatus 1000. Thus, the costs are reduced according to the present application.

A multi-energy complementary energy station is provided according to a fourth aspect of the present application, which includes a cooling system 100 as described in any of the above embodiments, or a power conversion apparatus 1000 as described in any of the above embodiments, or a power conversion system 10000 as described in any of the above embodiments.

Since the multi-energy complementary energy station provided in the present application includes the cooling system 100 as described in any of the above embodiments, the power conversion apparatus 1000 as described in any of the above embodiments, or the power conversion system 10000 as described in any of the above embodiments, all the beneficial effects associated with the above cooling system 100, the power conversion apparatus 1000 or the power conversion system 10000 are possessed by the multi-energy complementary energy station disclosed in the present application.

The embodiments in the specification are described in a progressive manner. Each of the embodiments focuses on the difference from other embodiments, and references may be made among these embodiments with respect to the same or similar parts.

The foregoing description of the disclosed embodiments enables those skilled in the art to implement or utilize the present application. Various modifications made to the embodiments are apparent to those skilled in the art. The general principles defined herein may be implemented in other embodiments without departing from the spirit or scope of the present application. Therefore, the present application is not be limited to the embodiments shown herein, but has the widest scope in accordance with the principles and the novel features disclosed herein.

Throughout this specification, the description with reference to the terms such as "an embodiment", "example", "specific example" or the like means that specific features, structures, materials or characteristics described in conjunction with this embodiment or example are included in at least another embodiment or example of the present application. In this specification, schematic expressions of the above terms do not necessarily refer to the same embodiment or example. Furthermore, the specific features, structures, materials or characteristics described may be combined in any suitable manner in any one or more embodiments or examples.

The above preferred embodiments disclosed in the present application are merely intended to help explain the present application. The preferred embodiments do not describe all the details exhaustively, and the present application is not limited to the specific embodiments. Obviously, many modifications and variations can be made based on the content of this specification. The embodiments are selected and described in detail herein to better explain the principles and practical applications of the present application, so that those skilled in the art can well understand and utilize the present application. The present application is limited only by the claims and the widest scope and equivalents thereof.

## Claims

1. A cooling system (100) for a power conversion apparatus (1000), wherein the power conversion apparatus (1000) comprises a protective enclosure (200) and to-be-cooled devices (300) located within the protective enclosure (200),
wherein the cooling system (100) comprises a cold plate (101), and
wherein the cold plate (101) is configured to be attached to a wall of the protective enclosure (200); or the cold plate (101) is configured to be connected to an opening formed in the protective enclosure (200) and to be in direct or indirect contact with the to-be-cooled devices (300).

2. The cooling system (100) according to claim 1, wherein the cold plate (101) is configured to be positioned outside the protective enclosure (200) and to be attached to an outer side of the wall of the protective enclosure (200), or
the cold plate (101) is configured to be positioned inside the protective enclosure (200) and to be attached to an inner side of the wall of the protective enclosure (200).

3. The cooling system (100) according to claim 1, wherein the cold plate (101) is configured to extend into the protective enclosure (200) through the opening such as to directly abut against the to-be-cooled devices (300) to achieve direct contact therebetween, or
wherein the cooling system further comprises a heat dissipation member arranged in the opening, such that the to-be-cooled devices (300) and the cold plate (101) are respectively attached to both sides of the heat dissipation member to achieve indirect contact therebetween.

4. The cooling system (100) according to claim 1, wherein there is provided at least one cold plate (101), which is attached to at least one wall of the protective enclosure (200).

5. The cooling system (100) according to claim 4, wherein there is provided one cold plate (101), which is configured to be directly or indirectly attached to all of the to-be-cooled devices (300) through the opening, or the cold plate (101) is configured to be attached to all of the to-be-cooled devices (300) via the wall of the protective enclosure (200); or
there are provided at least two cold plates (101), and the cold plates (101) are arranged in one-to-one correspondence with the to-be-cooled devices (300), and are directly or indirectly attached to the to-be-cooled devices (300) through the opening, respectively; or the cold plates (101) are arranged in one-to-one correspondence with the to-be-cooled devices (300), and are attached to the to-be-cooled devices via the wall of the protective enclosure (200); or a same cold plate (101) is directly or indirectly attached to a same type of to-be-cooled devices (300) through the opening; or a same cold plate (101) is attached to a same type of to-be-cooled devices (300) via the wall of the protective enclosure (200); or a same cold plate (101) is configured to be directly or indirectly attached to at least two different types of to-be-cooled devices (300) through the opening; or a same cold plate (101) is configured to be attached to at least two different types of to-be-cooled devices (300) via the wall of the protective enclosure (200).

6. The cooling system (100) according to claim 4, wherein there are provided two cold plates (101), which are arranged on two opposite walls of the protective enclosure (200), respectively, and the to-be-cooled devices (300) and the cold plates (101) are attached to different walls of the protective enclosure (200).

7. The cooling system (100) according to claim 1, wherein at least one rib structure (101a) is provided within the cold plate (101).

8. The cooling system (100) according to claim 1, further comprising a first fan (109), wherein
the first fan (109) is mounted within the protective enclosure (200) and is configured to induce turbulence in the protective enclosure (200).

9. The cooling system (100) according to any one of claims 1 to 8, further comprising a first heat exchanger (102), wherein
the first heat exchanger (102) is disposed within the protective enclosure (200), the to-be-cooled devices (300) comprises a magnetic device (301) and a power device (302), and at least one of the magnetic device (301) is arranged around at least one side of the first heat exchanger (102), and at least one of the power device (302) is attached to the cold plate (101) directly or indirectly via the wall of the protective enclosure (200).

10. The cooling system (100) according to claim 9, wherein there are provided at least two first heat exchangers (102), and the magnetic devices (301) are arranged in one-to-one correspondence with the first heat exchangers (102); or
there are provided at least two first heat exchangers (102), wherein at least one of the first heat exchangers (102) is arranged in one-to-one correspondence with the magnetic device (301), and at least two other magnetic devices (301) are arranged around one side of at least one other first heat exchanger (102).

11. The cooling system (100) according to claim 9, wherein a first accommodating enclosure (103) is provided within the protective enclosure (200) to accommodate the first heat exchanger (102) and the magnetic device (301) arranged around the first heat exchanger (102).

12. The cooling system (100) according to claim 9, wherein a cooling medium inlet of the first heat exchanger (102) is in communication with a cooling medium outlet of the cold plate (101); or
the cooling medium inlet of the first heat exchanger (102) is in communication with a cooling medium inlet of the cold plate (101), and a cooling medium outlet of the first heat exchanger (102) is in communication with the cooling medium outlet of the cold plate (101); or
the cooling medium inlet of the cold plate (101) is configured to input a cooling medium and is in communication with a first end of a first on-off valve (110), a second end of the first on-off valve (110) is in communication with both the cooling medium inlet of the first heat exchanger (102) and a first end of a second on-off valve (111), a second end of the second on-off valve (111) is in communication with both the cooling medium outlet of the cold plate (101) and a first end of a third on-off valve (112), and a second end of the third on-off valve (112) and the cooling medium outlet of the first heat exchanger (102) are configured to output the cooling medium.

13. The cooling system (100) according to any one of claims 1 to 8, further comprising a liquid cooling circulation system arranged outside the protective enclosure (200), wherein
the liquid cooling circulation system comprises a driving pump (104) and a second heat exchanger (105), wherein the driving pump (104) is at least configured to supply a driving force required for circulation of a cooling medium in the cold plate (101), and the second heat exchanger (105) is at least configured to cool the cooling medium output from the cold plate (101).

14. The cooling system (100) according to claim 13, further comprising a second accommodating enclosure (114), wherein
the second accommodating enclosure (114) is disposed outside the protective enclosure (200) and is configured to at least accommodate the liquid cooling circulation system.

15. The cooling system (100) according to claim 13, wherein the driving pump (104) is integrated with the second heat exchanger (105), or
the second heat exchanger (105) is a secondary heat exchanger having a compressor system.

16. The cooling system (100) according to claim 13, wherein the second heat exchanger (105) is arranged above the protective enclosure (200) and is configured to cover at least a portion of a top end of the protective enclosure (200).

17. The cooling system (100) according to claim 16, wherein the second heat exchanger (105) is in the shape of a flat plate, an inclined plate, a V-shaped plate, a W-shaped plate or a wave.

18. The cooling system (100) according to claim 13, wherein the liquid cooling circulation system further comprises a water storage device (106), and
the water storage device (106) is configured to store the cooling medium.

19. The cooling system (100) according to claim 18, wherein the water storage device (106) is integrated with the driving pump (104); or
the water storage device (106) is integrated with both the driving pump (104) and the second heat exchanger (105).

20. The cooling system (100) according to claim 13, wherein the liquid cooling circulation system further comprises a heating device (107), and
the heating device (107) is at least configured to heat the cooling medium input into the cold plate (101).

21. The cooling system (100) according to claim 13, wherein the liquid cooling circulation system further comprises a filter (108), and
the filter (108) is at least configured to filter the cooling medium input into the cold plate (101).

22. The cooling system (100) according to any one of claims 1 to 8, further comprising a second fan (113) disposed outside the protective enclosure (200), wherein
the second fan (1123) is connected to the cold plate (101) via an air duct and is configured to blow cold air into the cold plate (101).

23. A power conversion apparatus (1000), comprising a protective enclosure (200), to-be-cooled devices (300), and the cooling system (100) according to any one of claims 1 to 22, wherein
the to-be-cooled devices (300) are disposed within the protective enclosure (200), and the to-be-cooled devices (300) comprise a magnetic device (301) and a power device (302), and
the cold plate (101) of the cooling system (100) is at least configured to cool the power device (302).

24. A power conversion system (10000), comprising a plurality of power conversion apparatuses (1000) according to claim 23, wherein the plurality of power conversion apparatuses (1000) share a single liquid cooling circulation system.

25. A multi-energy complementary energy station, comprising the cooling system (100) according to any one of claims 1 to 22, the power conversion apparatus (1000) according to claim 23, or the power conversion system (10000) according to claim 24.
